# EUROPEAN PATENT APPLICATION

(11) **EP 4 141 899 A1**
(43) Date of publication of application: **01.03.2023**
(21) Application number: 22188052.9
(22) Date of filing: 01.08.2022
(51) Int. Cl.: H01F 41/04

(54) **METHOD OF MANUFACTURING INDUCTOR-EMBEDDED SUBSTRATE**

(30) Priority: 30.08.2021 JP 2021140271
(71) Applicant: AJINOMOTO CO., INC., Chuo-ku Tokyo 104-8315 (JP)
(72) Inventor: TANAKA, Takayuki, Kawasaki-shi (JP); OOYAMA, Hideki, Kawasaki-shi (JP); HOMMA, Tatsuya, Kawasaki-shi (JP)
(74) Representative: Mewburn Ellis LLP

(57) **Abstract**

A method of manufacturing an inductor embedded substrate, the method comprising the following process (A) to process (C) in this order: (A) filling a resin composition containing magnetic powder into a first through-hole that is formed in a substrate having first and second main surfaces to run between the first and the second main surfaces to form a magnetic layer; (B) laminating a metal foil-attached resin sheet containing metal foil and a resin composition layer onto the substrate such that the resin composition layer is bonded to the substrate, and curing the resin composition layer to form an insulation layer; and (C) forming a second through-hole that runs through the metal foil, the insulation layer, and the magnetic layer.

## Description

### BACKGROUND OF THE INVENTION

### 1. Field of the Invention

This invention relates to a method of manufacturing an inductor-embedded substrate.

### 2. Description of the Related Art

Inductor-embedded substrates having inductors embedded in circuit boards, such as printed wiring boards, are typically formed of resin compositions containing magnetic powder. For the inductors included in the inductor-embedded substrates, there are known methods in order to increase an inductance of the inductor: increasing a magnetic powder content in a resin composition; and increasing an effective magnetic permeability of a magnetic material that is a cured product of the resin composition.

For example, an inductor-embedded component described in Japanese Patent Application Laid-open No. 2021-86856 is provided with a magnetic material resin that is filled into an opening in a core substrate and has a second through-hole, and a second through-hole conductor formed of a metal film that is provided in the second through-hole, in which the magnetic material resin contains an iron oxide filler, and the magnetic material resin is in contact with the metal film in the structure.

### SUMMARY OF THE INVENTION

In Japanese Patent Application Laid-open No. 2021-86856, a conductor layer is formed on a surface of the magnetic material resin by etching treatment, but an etching solution used in the etching treatment may elute or change properties of the magnetic powder contained in the magnetic material resin. For example, when an iron filler is used as the magnetic powder, the iron filler is eluded or degenerated by a chemical, and then the magnetic material resin is degraded. Therefore, in Japanese Patent Application Laid-open No. 2021-86856, an iron oxide filler is used as the magnetic powder with excellent resistance to the chemical used in the roughening treatment. However, the iron oxide filler has an inferior magnetic property such as relative permeability, and may not provide a high inductance. Therefore, there remains a demand for methods of manufacturing an inductor-embedded substrate with the use of the magnetic powder with excellent magnetic properties, such as iron filler.

The present invention has been accomplished in view of the above problems, and is aimed at providing a manufacturing method capable of manufacturing an inductor-embedded substrate using magnetic powder other than iron oxide filler.

As a result of diligent research to achieve the above-mentioned purpose, the inventors of the present invention found that the inductor-embedded substrate can be manufactured by providing steps of: filling a through-hole in the substrate with a magnetic paste to form a magnetic layer; then laminating a metal-foil-attached resin sheet on the substrate such that a resin composition layer is bonded to the substrate before forming a second through-hole in the magnetic layer; and then curing the resin composition layer to provide an insulating layer without the need for the iron oxide filler as the magnetic powder contained in the magnetic paste, and completed the present invention.

In other words, the present invention includes the following.
[1] A method of manufacturing an inductor embedded substrate, the method comprising following process (A) to process (C) in this order:
   (A) filling a resin composition containing magnetic powder into a first through-hole that is formed in a substrate having first and second main surfaces to run between the first and the second main surfaces to form a magnetic layer ;
   (B) laminating a metal foil-attached resin sheet containing metal foil and a resin composition layer onto the substrate such that the resin composition layer is bonded to the substrate, and curing the resin composition layer to form an insulation layer; and
   (C) forming a second through-hole that runs through the metal foil, the insulation layer, and the magnetic layer.
[2] The method of manufacturing the inductor embedded substrate according to [1], the method further comprising after process (C):
   (D-1) forming a plating film in the second through-hole, filling and curing an insulation paste into the second through-hole in which the plating film is formed; and
   (E-1) forming a patterned conductive layer.
[3] The method of manufacturing the inductor embedded substrate according to [1], the method further comprising after process (C):
   (D-2) filling the second through-hole with an electrically conductive paste and curing the electrically conductive paste; and
   (E-2) forming a patterned conductive layer.
[4] The method of manufacturing the inductor embedded substrate according to any one of [1] to [3], wherein the magnetic powder is at least one type selected from pure iron powder and iron alloy metal powder.
[5] The method of manufacturing the inductor embedded substrate according to any one of [1] to [4], wherein the metal foil includes copper foil.
[6] The method of manufacturing the inductor embedded substrate according to any one of [1] to [5], the method further comprising forming the first through-hole that runs between the first and the second main surfaces of the substrate.

### EFFECT OF THW INVENTION

According to the present invention, there can be provided a manufacturing method capable of manufacturing an inductor-embedded substrate using magnetic powder other than iron oxide filler.

### BRIEF DESCRIPTION OF THE DRAWINGS

Fig. 1 is a schematic cross-sectional view of a substrate as one example of a method of manufacturing a circuit board according to first and second embodiments;
Fig. 2 is a schematic cross-sectional view of the substrate provided with a first through-hole as one example of the method of manufacturing the circuit board according to first and second embodiments;
Fig. 3 is a schematic cross-sectional view of the substrate with a magnetic layer formed in a through-hole as one example of the method of manufacturing the circuit board according to first and second embodiments;
Fig. 4 is a schematic cross-sectional view representing a metal foil-attached resin sheet bonded to the substrate as one example of the method of manufacturing the circuit board according to first and second embodiments;
Fig. 5 is a schematic cross-sectional view representing a second through-hole formed as one example of the method of manufacturing the circuit board according to first and second embodiments;
Fig. 6 is a schematic cross-sectional view of the substrate obtained after forming a plating film as one example of the method of manufacturing the circuit board according to first embodiment;
Fig. 7 is a schematic cross-sectional view of the substrate obtained after forming an insulating cured product layer as one example of the method of manufacturing the circuit board according to first embodiment;
Fig. 8 is a schematic cross-sectional view of the substrate obtained after forming a conductive layer as one example of the method of manufacturing the circuit board according to first embodiment;
Fig. 9 is a schematic cross-sectional view of the substrate obtained after forming a patterned conductive layer as one example of the method of manufacturing the circuit board according to first embodiment;
Fig. 10 is a schematic cross-sectional view of the substrate obtained after forming an electrically conductive layer as one example of the method of manufacturing the circuit board according to second embodiment;
Fig. 11 is a schematic cross-sectional view of the substrate obtained after forming the conductive layer as one example of the method of manufacturing the circuit board according to second embodiment; and
Fig. 12 is a schematic cross-sectional view of the substrate obtained after forming the patterned conductive layer as one example of the method of manufacturing the circuit board according to second embodiment.

### DETAILED DESCRIPTION OF THE PREFERRED EMBODIMENTS

Hereinafter, embodiments of the present invention are explained with reference to drawings. Each drawing is intended only to schematically represent shapes, sizes, and arrangement of components to such an extent that the present invention can be understood. The present invention is not limited by the following explanations, and each component can be modified as appropriate. In the drawings used for the following explanations, like components are designated by like reference numerals and may be dispensed with duplicated explanations. The configurations according to the embodiments of the present invention are not necessarily manufactured or used according to the arrangement illustrated in the illustrated examples.

A method of manufacturing an inductor embedded substrate according to the present invention includes:
(A) filling a resin composition containing magnetic powder into a first through-hole that is formed in a substrate having first and second main surfaces to run between the first and the second main surfaces to form a magnetic layer;
(B) laminating a metal foil-attached resin sheet containing metal foil and a resin composition layer onto the substrate such that the resin composition layer is bonded to the substrate, and curing the resin composition layer to form an insulating layer; and
(C) forming a second through-hole that runs through the metal foil, the insulating layer, and the magnetic layer. The present invention is performed in the order of the process (A) through process (C).

The method of manufacturing the inductor embedded substrate according to first embodiment of the present invention may include after process (C):
(D-1) forming a plating film in the second through-hole, filling and curing an insulation paste into the second through-hole in which the plating film is formed; and
(E-1) forming a patterned conductive layer.

The method of manufacturing the inductor embedded substrate according to second embodiment of the present invention may include after process (C):
(D-2) filling the second through-hole with an electrically conductive paste and curing the electrically conductive paste; and
(E-2) forming the patterned conductive layer.

In the case of forming the patterned conductive layer on the magnetic layer by plating, an etching treatment is required. The type of magnetic powder was limited to iron oxide filler because of the possibility of elusion or change of properties of the magnetic powder by the etchant used in the etching treatment.

In the case of forming the insulating layer on the magnetic layer and then forming the patterned conductive layer on the insulating layer, it is required that the insulating layer is roughened and then treated by plating in order to improve adhesive property of the patterned conductive layer. However, the roughening treatment to the insulating layer causes a chemical used in the roughening treatment to enter into the second through-hole and come into contact with the magnetic layer, possibly causing the elusion or the change of properties of the magnetic powder. Thus, the type of the magnetic powder was limited to iron oxide filler.

In contrast, the manufacturing method according to the present invention allows the patterned conductive layer to be formed by plating after the insulating layer and the metal foil are provided on the magnetic layer. In this manufacturing method, the patterned conductive layer can be formed on the metal foil. The metal foil can strongly adhere to the conductive layer such as the patterned conductive layer formed on the metal foil without the roughening treatment. The roughening treatment is not required, and therefore the magnetic layer can be prevented from coming into contact with the chemical used for the roughening treatment, eliminating the limitation to the iron oxide filler as the type of the magnetic powder. Therefore, the inductor embedded substrates can be manufactured with the magnetic powder other than the iron oxide filler. Since the magnetic powder other than the iron oxide filler can be used, it is possible to employ the magnetic powder such as iron filler with magnetic properties superior to the iron oxide filler, making it possible to achieve excellent inductance in general according to the aforementioned manufacturing method.

The method of manufacturing the inductor-embedded substrate according to the first and the second embodiments is described below. In the first embodiment, it is preferable to perform process (A) through process (E-1) in this order. In the second embodiment, it is preferable to perform process (A) through process (E-2) in this order.

### [First embodiment]

### <Process (A)>

At process (A), the magnetic paste containing the magnetic powder is filled into the first through-hole that is formed in the substrate having the first and the second main surfaces to run between the first and the second main surfaces to form the magnetic layer. The second main surface corresponds to a main surface opposite to the first main surface.

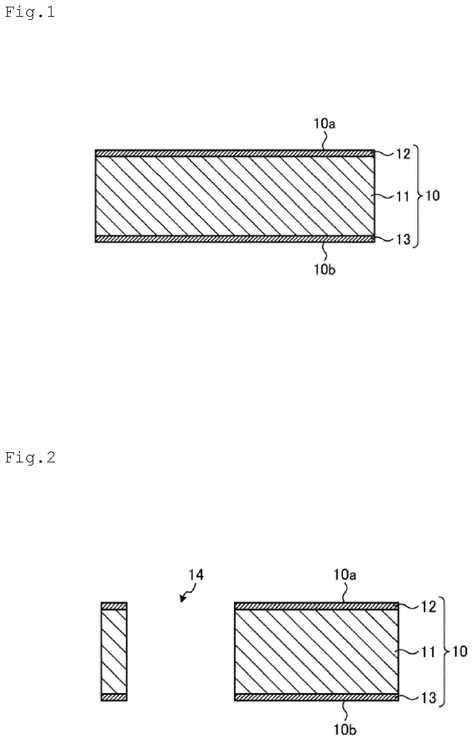

To perform process (A), it may be possible to include preparing a substrate 10 provided with a support substrate 11, and a first metal layer 12 and a second metal layer 13 that are made of a metal such as copper foil and provided on both surfaces of the support substrate 11, as illustrated in Fig. 1 as one example. Examples of materials for the support substrate 11 include insulating base materials such as glass epoxy substrates, metal substrates, polyester substrates, polyimide substrates, BT resin substrates, and thermosetting polyphenylene ether substrates. Examples of materials for the first and the second metal layers 11, 12 include carrier-attached copper foil and materials for the conductive layer described below.

It may be possible to include forming a first through-hole 14 that runs between the first and the second main surfaces 10a and 10b of the substrate 10, as illustrated in Fig. 2 as one example. The first through hole 14 can be formed by drilling, laser irradiation, plasma irradiation, or the like. Specifically, the first through hole 14 can be formed by forming a through hole in the substrate 10 using a drill or the like.

The first through hole 14 can be formed with a drilling machine commercially available. Examples of the commercially available drilling machine include "ND-1S211" manufactured by Hitachi Via Mechanics, Inc.

Fig. 2 illustrates a single first through-hole 14, but a plurality of the first through-holes 14 can be provided to be spaced away from each other at a predetermined interval. With a plurality of the first through-holes 14 provided, a plurality of inductor structures can be formed in the substrate 10.

An opening diameter of the first through-hole 14 is not particularly limited and may be determined as appropriate according to a specific design of the inductor-embedded substrate to be manufactured. For example, the opening diameter of the first through-hole 14 is preferably 1.0 mm or less, more preferably 0.8 mm or less, from the viewpoint of maintaining the rigidity of the substrate 10. The lower limit is not particularly limited, but is preferably 0.2 mm or more, and more preferably 0.25 mm or more, from the viewpoint of the formability of the second through-hole described below.

A thickness of the substrate 10 is not particularly limited and may be determined according to the specific design of the inductor-embedded substrate to be manufactured. For example, the thickness of the substrate 10 is preferably 0.3 µm or more, more preferably 0.5 µm or more, and still more preferably 0.7 µm or more from the viewpoint of improving the inductor performance of the inductor embedded substrate. The upper limit is not particularly limited, but is preferably 2 mm or less, more preferably 1.7 mm or less, and still more preferably 1.5 mm or less.

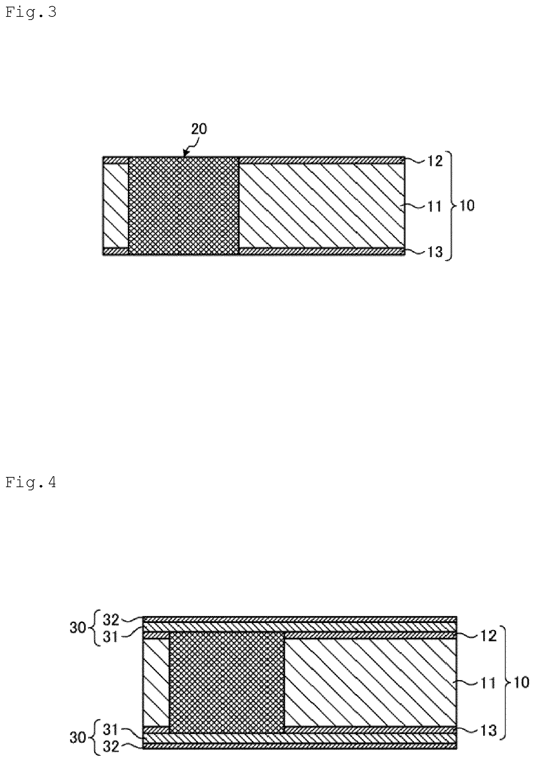

After preparation of the substrate 10 in which the first through-hole 14 is formed, the magnetic paste is filled into the first through-hole 14 and cured by heating to form the magnetic layer 20 in the first through-hole 14, as illustrated in Fig. 3 as one example. The magnetic paste is described in detail below.

Examples of the method of filling the magnetic paste include a method of filling the first through-hole 14 with the magnetic paste with use of a squeegee, a method of filling with the magnetic paste with use of a cartridge, a method of filling with the magnetic paste by mask printing, a roll coat method, and an inkjet method.

The condition for thermally curing the magnetic paste differs depending on the composition and type of the magnetic paste, but the curing temperature is preferably 120°C or more, more preferably 130°C or more, still more preferably 150°C or more, preferably 240°C or less, more preferably 220°C or less, still more preferably 200°C or less. The time for curing the magnetic paste is preferably 5 minutes or more, more preferably 10 minutes or more, still more preferably 15 minutes or more, preferably 120 minutes or less, more preferably 100 minutes or less, still more preferably 90 minutes or less.

The degree of curing the magnetic layer 20 is preferably 80% or more, more preferably 85% or more, and still more preferably 90% or more. The degree of the curing can be measured using a differential scanning calorimetry system, for example.

Before cured by heating, the magnetic paste may be subjected to a preheat treatment to be heated at a temperature lower than the curing temperature. For example, before cured by heating, the magnetic paste may be preheated typically at a temperature of 50°C or more and less than 120°C (preferably 60°C or more and 110°C or less, more preferably 70°C or more and 100°C or less), typically for 5 minutes or more (preferably from 5 minutes to 150 minutes, more preferably from 15 minutes to 120 minutes).

After the formation of the magnetic layer 20, it may be possible to include removing by polishing an excessive amount of the magnetic layer 20 that projects out from or adheres to the substrate 10, and smoothening the magnetic layer 20, as required. The polishing method may be a method capable of polishing the excessive magnetic layer 20 that projects out from or adheres to the substrate 10. Examples of such a polishing method include buffing polishing and belt polishing. Examples of commercially available buffing polishing machine includes "NT-700IM" manufactured by Ishiihyoki Co., Ltd.

The arithmetic average roughness (Ra) of the polished surface of the magnetic layer 20 is preferably 300 nm or more, more preferably 350 nm or more, and still more preferably 400 nm or more from the viewpoint of improving adhesion with the insulating layer described below. The upper limit is preferably 1000 nm or less, more preferably 900 nm or less, and still more preferably 800 nm or less. The arithmetic surface roughness (Ra) can be measured using a non-contact surface roughness meter, for example.

### - Magnetic paste -

The magnetic paste used to form the magnetic layer contains magnetic powder. The magnetic paste may contain a binder resin, a dispersant, a curing accelerator, or another additive as required.

The magnetic powder is an inorganic filler with a relative permeability greater than 1. From the viewpoint of improving the magnetic properties of the inductor-embedded substrate, the magnetic powder is preferably at least one type selected from pure iron powder and iron alloy metal powder. Examples of the iron alloy metal powder include Fe-Si alloy powder, Fe-Si-Al alloy powder, Fe-Cr alloy powder, Fe-Cr-Si alloy powder, Fe-Ni-Cr alloy powder, Fe-Cr-Al alloy powder, Fe-Ni alloy powder, Fe-Ni-Mo alloy powder, Fe-Ni-Mo-Cu alloy powder, Fe-Co alloy powder, and Fe-Ni-Co alloy powder. The iron alloy metal powder preferably contains at least one type selected from Si, Cr, Al, Ni and Co.

A commercially available magnetic powder can be used as the magnetic powder. Examples of the commercially available magnetic powder include: "PST-S" manufactured by Sanyo Special Steel Co., Ltd.; "AW2-08", "AW2-08PF20F", "AW2-08PF10F", "AW2-08PF3F", "Fe-3.5Si-4.5CrPF20F", "Fe-50NiPF20F", and "Fe-80Ni-4MoPF20F" manufactured by Epson Atmix Corporation; "JR09P2" manufactured by Japan Metals & Chemicals Co., Ltd.; "Nanotek" manufactured by CIK NanoTek Corporation; "JEMK-S" and "JEMK-H" manufactured by Kinsei Matec Co., Ltd.; and "Yttrium iron oxide" manufactured by Sigma-Aldrich Co. LLC. One type of the magnetic powder may be used alone, or two or more types thereof may be used in combination.

The magnetic powder preferably has a spherical shape. A value (aspect ratio) obtained by dividing the length of the major axis of the magnetic powder by the length of the minor axis is preferably 2 or less, more preferably 1.5 or less, and still more preferably 1.2 or less. In general, when the magnetic powder has not spherical shape but a flat shape, relative permeability can be more easily enhanced. However, the magnetic powder having a spherical shaped is particularly preferably used because, usually, magnetic loss can be reduced and a paste having a desirable viscosity can be achieved

From the viewpoint of improving the relative permeability, the average particle size of the magnetic powder is preferably 0.01 µm or more, more preferably 0.5 µm or more, and still more preferably 1 µm or more. In addition, the average particle size of the magnetic powder is preferably 10 µm or less, more preferably 9 µm or less, and still more preferably 8 µm or less.

The average particle size of the magnetic powder can be measured by laser diffraction and scattering based on Mie scattering theory. Specifically, the average particle size of the magnetic powder can be measured by creating a particle size distribution based on volume and measuring a median diameter of the distribution as the average particle size using a laser diffraction scattering particle size distribution analyzer. The magnetic powder dispersed in water by ultrasound is preferably used as the sample to be measured. Examples of the laser diffraction scattering particle size distribution analyzer include "LA-500" manufactured by Horiba, Ltd. and "SALD-2200" by Shimadzu Corporation.

The specific surface area of the magnetic powder is preferably 0.05 m²/g or more, more preferably 0.1 m²/g or more, and still more preferably 0.3 m²/g or more from the viewpoint of improving the relative permeability. The specific surface area of the magnetic powder is preferably 10 m²/g or less, more preferably 8 m²/g or less, and still more preferably 5 m²/g or less. The specific surface area of the magnetic powder can be measured by the BET method.

The content (% by volume) of the magnetic powder is preferably 40% by volume or more, more preferably 50% by volume or more, and still more preferably 60% by volume or more with respect to 100% by volume of a non-volatile component in the magnetic paste, from the viewpoint of improving the relative permeability and reducing loss coefficient. The upper limit of the content (% by volume) is not particularly limited, but can be preferably 95% by volume or less, 90% by volume or less, and the like.

The content (% by mass) of the magnetic powder is preferably 70% by mass or more, more preferably 75% by mass or more, and still more preferably 80% by mass or more with respect to 100% by mass of the non-volatile component in the resin composition from the viewpoint of improving the relative permeability and reducing the loss coefficient. The upper limit of the content (% by mass) is not particularly limited, but can be preferably 99% by mass or less, 98% by mass or less, and the like.

The binder resin is not particularly limited as long as it is a resin that can cause the magnetic powder to be dispersed and bonded in the magnetic paste to form the magnetic layer.

Examples of the binder resin include: thermosetting resins such as epoxy resins, phenolic resins, naphthol resins, benzoxazine resins, active ester resins, cyanate ester resins, carbodiimide resins, amine resins, and acid anhydride resins; and thermoplastic resins such as phenoxy resins, acrylic resins, polyvinyl acetal resins, butyral resins, polyimide resins, polyamideimide resins, polyethersulfone resins, and polysulfone resins. As the binder resin, it is preferable to use the thermosetting resins in forming the insulating layer of the wiring circuit board. Among them, epoxy resin is preferred. One type of the binder resin may be used alone, or two or more types thereof may be used in combination.

Here, the term "curing agent" may refer to all components reacting with the epoxy resin to cure the magnetic paste, such as phenolic resins, naphthol resins, benzoxazine resins, active ester resins, cyanate ester resins, carbodiimide resins, amine resins, and acid anhydride resins.

The epoxy equivalent of the epoxy resin is preferably 50 g/eq. to 5000 g/eq., more preferably 50 g/eq. to 3000 g/eq., still more preferably 80 g/eq. to 2000 g/eq., and still further more preferably 110 g/eq. to 1000 g/eq. When the epoxy equivalent is within the above-mentioned range, the crosslinking density of the cured product is sufficient, whereby a magnetic layer having lower surface roughness can be offered. The epoxy equivalent weight can be measured according to JIS K7236 and refers to the mass of the resin containing one equivalent amount of epoxy groups.

The weight average molecular weight of the epoxy resin is preferably 100 to 5000, more preferably 250 to 3000, and still more preferably 400 to 1500. The weight average molecular weight of the epoxy resin is a weight average molecular weight that is a polystyrene conversion value measured by gel permeation chromatography (GPC) method.

When the binder resin contains the epoxy resin and the curing agent(s), the amount ratio of the epoxy resin to all of the curing agent(s) is the ratio of [total number of epoxy groups in the epoxy resin]:[total number of reactive groups in the curing agent(s)], and is preferably in the range of 1:0.01 to 1:5, more preferably 1:0.5 to 1:3, still more preferably 1:1 to 1:2. The term "number of epoxy groups in the epoxy resin" is the sum of all of the values obtained by dividing the mass of the non-volatile component(s) of the epoxy resin present in the magnetic paste by the epoxy equivalents. The term "number of active groups in the curing agent" is the sum of all of the values obtained by dividing the mass of non-volatile components of the curing agent present in the magnetic paste by the equivalents of the active groups.

From the viewpoint of causing the magnetic powder to be dispersed and bonded in the magnetic paste to form the magnetic layer, the content of the binder resin is preferably 1% by mass, 3% by mass, or 5% by mass or more, and preferably 25% by mass or less, 20% by mass or less, or 15% by mass or less, with respect to 100% by mass of the non-volatile component in the magnetic paste.

The magnetic paste may further contain a dispersant. The dispersant improves the dispersibility of the magnetic powder.

Examples of the dispersant include: phosphate ester dispersants such as polyoxyethylene alkylether phosphate; anionic dispersants such as sodium dodecylbenzyl sulfonate, sodium laurylate, and ammonium salts of polyoxyethylene alkyl ether sulfate; and nonionic dispersants such as organosiloxane dispersants, acetylene glycol, polyoxyethylene alkylethers, polyoxyethylene alkylesters, polyoxyethylene sorbitan fatty acid esters, polyoxyethylene alkylphenyl ethers, polyoxyethylene alkylamine, and polyoxyethylene alkylamide. Among these, the anionic dispersant is preferred. One type of the dispersant may be used alone, or two or more types thereof may be used in combination.

The content of the dispersant is preferably 0.1% by mass or more, 0.2% by mass or more, or 0.4% by mass or more with respect to 100% by mass of the non-volatile component in the magnetic paste, and the upper limit is preferably 5% by mass or less, 3% by mass or less, or 1% by mass or less.

The magnetic paste may further contain a curing accelerator. The use of the curing accelerator effectively facilitates the curing of the binder resin to increase the mechanical strength of the cured product. Examples of the curing accelerator include amine-based curing accelerators, imidazole-based curing accelerators, phosphorus-based curing accelerators, guanidine-based curing accelerators, and metal-based curing accelerators. From the viewpoint of obtaining magnetic pastes that exhibit moderate viscosity, the curing accelerator is preferably the amine-based curing accelerator or the imidazole-based curing accelerator, more preferably the imidazole-based curing accelerator. One type of the curing accelerator may be used alone, or two or more types thereof may be used in combination.

From the viewpoint of obtaining the magnetic paste that exhibits moderate viscosity the content of the curing accelerator is preferably 0.1% by mass or more, 0.2% by mass or more, or 0.3% by mass or more with respect to 100% by mass of the non-volatile component in the magnetic paste. In addition, the upper limit is preferably 3% by mass or less, 2% by mass or less, or 1% by mass or less.

The magnetic paste may further contain another additive as required. Examples of the relevant additive include radical polymerizable compounds, curing retardants such as triethyl borate, flame retardants, thickeners, defoamers, inorganic fillers (excluding magnetic powder), leveling agents, adhesion agents, and resin additives such as coloring agents.

From the viewpoint of capability of filling the first through hole sufficiently (and thus forming the desired magnetic layer), the viscosity of the magnetic paste (25°C) is preferably 20 Pa·s or more, more preferably 30 Pa·s or more, and still more preferably 40 Pa·s or more, and is typically 250 Pa·s or less, preferably 220 Pa·s or less, more preferably 200 Pa·s or less. The viscosity can be measured using an E-type viscometer while the temperature of the magnetic paste is held at 25 ± 2°C.

### <Process (B)>

At process (B), the metal foil-attached resin sheet containing the metal foil and the resin composition layer is laminated on the substrate such that the resin composition layer is bonded to the substrate. Then, the resin composition layer is cured. The curing of the resin composition layer provides the insulating layer formed of the cured product of the resin composition. Therefore, the insulating layer and metal foil are provided in this order on the magnetic layer. The metal foil-attached resin sheet is described below.

At process (B), as illustrated in Fig. 4 as an example, the metal foil-attached resin sheet 30, which contains the metal foil 32 and the resin composition layer 31 provided on the metal foil 32, is laminated on the substrate 10 so that the resin composition layer 31 is bonded to the substrate 10.

The resin composition layer 31 can be bonded to the substrate 10 by thermocompression bonding of the metal foil-attached resin sheet 30 to the substrate 10 from a side of the metal foil 32, for example. Examples of a member (referred to also as "thermocompression bonding member", hereinafter) used for the thermocompression bonding of the metal foil-attached resin sheet 30 to the substrate 10 include a heated metal plate (stainless steel (SUS) mirror plate or the like), a metal roll (SUS rolls) and the like. It is preferable to press through a sheet or the like made of an elastic material such as heat-resistant rubber so that the metal foil-attached resin sheet 30 is sufficiently fitted to bumps on the surface of the substrate 10, instead of directly bringing the thermocompression bonding member into contact with the metal foil-attached resin sheet 30 before pressing.

The temperature for the thermocompression bonding is preferably 80°C to 160°C, more preferably 90°C to 140°C, still more preferably 100°C to 120°C. The pressure for the thermocompression bonding is preferably 0.098 MPa to 1.77 MPa, more preferably 0.29 MPa to 1.47 MPa. The time for the thermocompression bonding is preferably 20 seconds to 400 seconds, more preferably 30 seconds to 300 seconds. The thermocompression bonding of the metal foil-attached resin sheet to the substrate is preferably performed under a reduced pressure condition at 26.7 hPa or less.

The resin composition layer 31 of the metal foil-attached resin sheet 30 can be bonded to the substrate 10 with use of a commercially available vacuum laminator. Examples of the commercially available vacuum laminator include a vacuum-pressurized laminator manufactured by Meiki Co., Ltd., a vacuum applicator manufactured by Nikko Materials, Co., Ltd.

After the metal foil-attached resin sheet 30 is bonded to the substrate 10, the laminated metal foil-attached resin sheet 30 may be treated for smoothing under normal pressure (atmospheric pressure) by pressing the thermocompression bonding member from the metal foil side, for example. The pressing of the smoothing treatment can be performed under the same condition as in the thermocompression bonding for the laminating. The smoothing treatment can be performed with a laminator commercially available. The laminating and the smoothing treatment may be performed continuously using the commercial vacuum laminator described above.

After the metal foil-attached resin sheet is laminated on the substrate, the resin composition layer is cured by heating to form the insulating layer.

The thermally curing condition for the resin composition layer 31 differs depending on the composition and type of the resin composition layer 31. The curing temperature is preferably 120°C or more, more preferably 130°C or more, still more preferably 150°C or more, preferably 240°C or less, more preferably 220°C or less, still more preferably 200°C or less. The time for curing the resin composition layer 31 is preferably 5 minutes or more, more preferably 10 minutes or more, still more preferably 15 minutes or more, preferably 120 minutes or less, more preferably 100 minutes or less, still more preferably 90 minutes or less.

### - Metal foil-attached resin sheet -

The metal foil-attached resin sheet includes the metal foil and the resin composition layer made of the resin composition provided on the metal foil. The resin composition preferably has a sufficient hardness and insulation property in its cured product. Examples of such a resin composition include compositions containing curable resins and their curing agents. As the curable resins, it is possible to use well-known conventional curable resins used in forming the insulating layer of printed wiring board. Among them, epoxy resins are preferred. Thus, the resin composition contains the epoxy resin and the curing agent. The resin composition may further contain an inorganic filler, a curing accelerator, and another additives as required.

### (Metal foil)

Examples of the metal foil include copper foil and aluminum foil. The copper foil is preferred. The copper foil may be made of a single metal of copper, or an alloy of copper and any of other metals (e.g., tin, chromium, silver, magnesium, nickel, zirconium, silicon, titanium, and the like).

The metal foil may have a single-layer structure or a multi-layer structure made of two or more of single metal layers or alloy layers made of different types of metals or alloys. Examples of the metal foil with a multi-layer structure include metal foil containing carrier metal foil and ultra-thin metal foil bonded to the carrier metal foil. Such metal foil with a multi-layer structure may include a release layer capable of releasing the ultra-thin metal foil from the carrier metal foil between the carrier metal foil and the ultra-thin metal foil. The release layer is not particularly limited as long as the ultra-thin metal foil can be released from the carrier metal foil. Examples of the release layer include: an alloy layer made of elements selected from the group consisting of Cr, Ni, Co, Fe, Mo, Ti, W, and P; and an organic film. When the multi-layered metal foil is used as the support, the resin composition layer is provided on the ultra-thin metal foil.

From the viewpoint of remarkably achieving the effect of the present invention, the thickness of the metal foil is preferably 9 µm or more, more preferably 10 µm or more, and still more preferably 11 µm or more. In addition, the upper limit is not particularly limited, but is preferably 30 µm or less, more preferably 20 µm or less, and still more preferably 15 µm or less. The metal foil may have a single-layer structure or a multi-layer structure. When the metal foil has the multi-layer structure, the overall thickness of the metal foil is preferably in this range, while the thickness of the ultra-thin metal foil may be 0.1 µm or more and 10 µm or less, for example.

The method of manufacturing the metal foil is not particularly limited, but can be a well-known method such as electrolysis and rolling, for example.

### (Resin composition)

Examples of the epoxy resin include bixylenol epoxy resin, bisphenol A epoxy resin, bisphenol F epoxy resin, bisphenol S epoxy resin, bisphenol AF epoxy resin, dicyclopentadiene epoxy resin, trisphenol epoxy resin, naphthol novolac epoxy resin, phenolic novolac epoxy resin, tert-butyl-catechol epoxy resin, naphthalene epoxy resin, naphthol epoxy resin, anthracene epoxy resin, glycidylamine epoxy resin, glycidylester epoxy resin, glycidylcyclohexane epoxy resin, cresol novolac epoxy resin, biphenyl epoxy resin, linear aliphatic epoxy resin, epoxy resin with butadiene structure, alicyclic epoxy resin, heterocyclic epoxy resin, spiro epoxy resin, cyclohexane epoxy resin, cyclohexane dimethanol epoxy resin, naphthylene ether epoxy resin, trimethylol epoxy resin, tetraphenylethane epoxy resin, and phenolphthalimidine epoxy resin. One type of the epoxy resin may be used alone, or two or more types thereof may be used in combination.

The epoxy resin includes an epoxy resin liquid at a temperature of 20°C (hereinafter referred to as "liquid epoxy resins") and an epoxy resins solid at a temperature of 20°C (hereinafter referred to as "solid epoxy resins"). The resin composition may contain only the liquid epoxy resin, only the solid epoxy resin, or a combination of the liquid epoxy resin and solid epoxy resin, as the epoxy resin.

The epoxy equivalent of the epoxy resin is preferably 50 g/eq. to 5000 g/eq., more preferably 50 g/eq. to 3000 g/eq., still more preferably 80 g/eq. to 2000 g/eq., and still further more preferably 110 g/eq. to 1000 g/eq. This range allows a cured body to have a sufficient crosslink density of the cured product of the resin composition. The epoxy equivalent is the mass of the epoxy resin containing one equivalent of epoxy groups. This epoxy equivalent can be measured according to JIS K7236.

The weight average molecular weight (Mw) of the epoxy resin is preferably 100 to 5000, more preferably 250 to 3000, and still more preferably 400 to 1500, from the viewpoint of achieving remarkably the desired effect of the present invention. The weight average molecular weight of the epoxy resin is the weight average molecular weight that is polystyrene conversion value measured by gel permeation chromatography (GPC) method.

From the viewpoint of obtaining the cured body exhibiting good mechanical strength and insulation reliability, the content of the epoxy resin is preferably 5% by mass or more, more preferably 10% by mass or more, and still more preferably 15% by mass or more, with respect to 100% by mass of the non-volatile component in the resin composition. The upper limit of the epoxy resin content is preferably 35% by mass or less, more preferably 30% by mass or less, and particularly preferably 25% by mass or less from the viewpoint of remarkably achieving the desired effect of the present invention.

Examples of the curing agent include active ester resins, phenolic resins, naphthol resins, benzoxazine resins, cyanate ester resins, carbodiimide resins, amine resins, and acid anhydride resins.

The amount ratio of the epoxy resin to all curing agents is preferably in the range of 1:0.01 to 1:5, more preferably 1:0.05 to 1:3, still more preferably 1:0.1 to 1:2 in the ratio of [total number of epoxy groups in the epoxy resin]:[total number of reactive groups in the curing agent(s)]. The term "number of epoxy groups in the epoxy resin" is the sum of all of the values obtained by dividing the mass of the non-volatile component(s) of the epoxy resin present in the resin composition by the epoxy equivalents. The term "number of active groups in the curing agent" is the sum of all of the values obtained by dividing the mass of non-volatile components of the curing agent present in the resin composition by the equivalents of the active groups. With the amount ratio of the epoxy resin to the curing agent(s) held within such a range, it is possible to obtain the cured body with excellent flexibility.

From the viewpoint of remarkably achieving the effect of the present invention, the content of the curing agent is preferably 1% by mass or more, more preferably 3% by mass or more, still more preferably 5% by mass or more, preferably 15% by mass or less, more preferably 10% by mass or less, still more preferably 8% by mass or less, with respect to 100% by mass of the non-volatile component in the resin composition.

The inorganic compound is used as a material of the inorganic filler. Examples of the inorganic filler include silica, alumina, glass, cordierite, silicon oxides, barium sulfate, barium carbonate, talc, clay, mica powder, zinc oxide, hydrotalcite, boehmite, aluminum hydroxide, magnesium hydroxide, calcium carbonate, magnesium carbonate, magnesium oxide, boron nitride, aluminum nitride, manganese nitride, aluminum borate, strontium carbonate, strontium titanate, calcium titanate, magnesium titanate, bismuth titanate, titanium oxide, zirconium oxide, barium titanate, barium zirconate titanate, barium zirconate, calcium zirconate, zirconium phosphate, and zirconium tungstate phosphate. Among these, silica is particularly preferred. Examples of the silica include amorphous silica, fused silica, crystalline silica, synthetic silica, and hollow silica. Spherical silica is preferred as the silica. One type of the inorganic filler may be used alone, or two or more types thereof may be used in combination. The inorganic filler refers to an inorganic filler with the relative permeability of 1.

From the viewpoint of remarkably achieving the desired effect of the invention, the average particle size of the inorganic filler is preferably 0.01 µm or more, more preferably 0.05 µm or more, particularly preferably 0.1 µm or more, preferably 5 µm or less, more preferably 2 µm or less, and still more preferably 1 µm or less.

The average particle size of the inorganic filler can be measured by laser diffraction and scattering method based on Mie scattering theory. Specifically, the average particle size of the inorganic filler can be measured by creating a particle size distribution based on volume and measuring a median diameter of the distribution as the average particle size using a laser diffraction scattering particle size distribution analyzer. The sample to be measured can be prepared by weighing 100 mg of the inorganic filler and 10 g of methylethyl ketone in a vial and dispersing them by ultrasound for 10 minutes. Using the laser diffraction scattering particle size distribution analyzer with blue and red light sources, the volume-based particle size distribution of the inorganic filler is measured using the flow cell method, and the average particle size is calculated as the median diameter from the particle size distribution obtained. Examples of the laser diffraction scattering particle size distribution analyzer include "LA-960" manufactured by Horiba, Ltd. and "SALD-2200" by Shimadzu Corporation.

The specific surface area of the inorganic filler is preferably 1 m²/g or more, more preferably 2 m²/g or more, and particularly preferably 3 m²/g or more, from the viewpoint of remarkably achieving the desired effect of the present invention. There is no particular limit on the upper limit, but the upper limit is preferably 60 m²/g or less, 50 m²/g or less, or 40 m²/g or less. The specific surface area is obtained using a full automatic BET specific surface area analyzer (Macsorb HM-1210 manufactured by Mountech Co., Ltd.) by adsorbing nitrogen gas on the sample surface, calculating the specific surface area using the BET multi-point method, and measuring the specific surface area of the inorganic filler.

The inorganic filler is preferably treated with a surface treatment agent from the viewpoint of improving moisture resistance and dispersibility. Examples of the surface treatment agent include: fluorine-containing silane coupling agents such as 3,3,3-trifluoropropyltrimethoxysilane; aminosilane coupling agents such as 3-aminopropyltriethoxysilane, N-phenyl-8-aminooctyl-trimethoxysilane, N-phenyl-3-aminopropyltrimethoxysilane; epoxysilane coupling agents such as 3-glycidoxypropyltrimethoxysilane; mercaptosilane coupling agents such as 3-mercaptopropyltrimethoxysilane; silane coupling agents; alkoxysilane such as phenyltrimethoxysilane; organosilazane compounds such as hexamethyldisilazane; and titanate coupling agents. One type of the surface treatment agent may be used alone, or two or more types thereof may be used in any combination.

The extent of surface treatment with the surface treatment agent is preferably within a predetermined range from the viewpoint of improving the dispersibility of the inorganic filler. Specifically, 100 mass parts of the inorganic filler is preferably surface-treated with 0.2 to 5 mass parts of the surface treatment agent, preferably surface-treated with 0.2 to 3 mass parts, and preferably surface-treated with 0.3 to 2 mass parts.

From the viewpoint of remarkably achieving the effect of the present invention, the content of the inorganic filler is preferably 40% by mass or more, more preferably 45% by mass or more, more preferably 50% by mass or more, preferably 85% by mass or less, preferably 80% by mass or less, and preferably 75% by mass or less, with respect to 100% by mass of the non-volatile component in the resin composition.

The curing accelerator and other additives are the same as those containable in the magnetic paste.

The metal foil-attached resin sheet can be manufactured by dissolving the resin composition in an organic solvent to prepare a resin varnish, applying the resin varnish on the metal foil using a die coater or the like, and further drying to form the resin composition layer, for example.

The thickness of the resin composition layer is preferably 5 µm or more, more preferably 10 µm or more, and still more preferably 20 µm or more, from the viewpoint of remarkably achieving the effect of the present invention. The upper limit is not particularly limited, but is preferably 50 µm or less, more preferably 45 µm or less, and still more preferably 40 µm or less.

Examples of the organic solvent include: ketones such as methylethyl ketone (MEK) and cyclohexanone; aromatic hydrocarbons such as xylene and tetramethylbenzene; glycol ethers such as methyl cellosolve, butyl cellosolve, methyl carbitol, butyl carbitol, propylene glycol monomethylether, dipropylene glycol monoethylether, dipropylene glycol diethylether, and triethylene glycol monoethylether; esters such as ethyl acetate, butyl acetate, butyl cellosolve acetate, carbitol acetate, ethyl diglycol acetate; aliphatic hydrocarbons such as octane and decane; and petroleum solvents such as petroleum ethers, petroleum naphtha, hydrogenated petroleum naphtha, and solvent naphtha. One type selected among these solvents may be used alone, or two or more types thereof may be used in combination.

### <Process (C)>

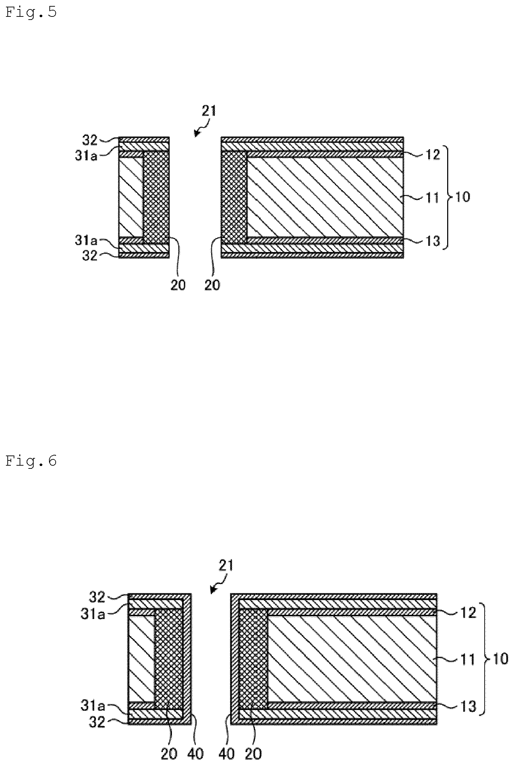

The process (C) involves formation of the second through-hole 21 that runs through the metal foil 32, the insulating layer 31a, and the magnetic layer 20, as illustrated in Fig. 5 as one example. The second through hole 21 can be formed in the same way as in the method of forming the first through hole 14.

The opening diameter of the second through-hole 21 is not particularly limited as long as it is smaller than that of the first through-hole 14, and may be determined as appropriate according to the specific design of the inductor embedded substrate to be manufactured. For example, the opening diameter of the second through-hole 21 is preferably 0.4 mm or less, more preferably 0.3 mm or less, from the viewpoint of improving inductor performance. The lower limit is not particularly limited, but is preferably 0.05 mm or more and more preferably 0.1 mm or more from the viewpoint of the formability of the second through-hole.

Forming the second through-hole can be followed by washing with water to remove smear (processing residue) inside the second through-hole.

The water washing is preferably performed under high pressure. The pressure in the water washing is preferably 1 MPa or more, more preferably 1.5 MPa or more, still more preferably 2 MPa or more, preferably 10 MPa or less, more preferably 8 MPa or less, still more preferably 5 MPa or less.

The time for the water washing is preferably 1 second or more, more preferably 5 seconds or more, still more preferably 10 seconds or more, preferably 60 seconds or less, more preferably 30 seconds or less, still more preferably 20 seconds or less.

### <Process (D-1)>

In the first embodiment, process (D-1) is performed after process (C). At process (D-1), a plating film is formed in the second through-hole. The insulation paste is filled into the second through-hole formed with the plating film and then cured.

At process (D-1), first, the plating film 40 is formed in the second through-hole 21, as illustrated in Fig. 6 as an example. At forming the plating film 40 in the second through-hole 21, the plating film 40 may be formed also in a portion other than the second through-hole 21 of the substrate 10. The plating film 40 is formed by the plating method. Examples of the plating method according to preferred embodiments include a semi-additive method and a full-additive method.

The thickness of the plating film 40 is preferably 70 µm or less, more preferably 60 µm or less, still more preferably 50 µm or less, still further more preferably 40 µm or less, and particularly preferably 30 µm or less, 20 µm or less, 15 µm or less, or 10 µm or less from the viewpoint of thinning. The lower limit is preferably 1 µm or more, more preferably 3 µm or more, and still more preferably 5 µm or more.

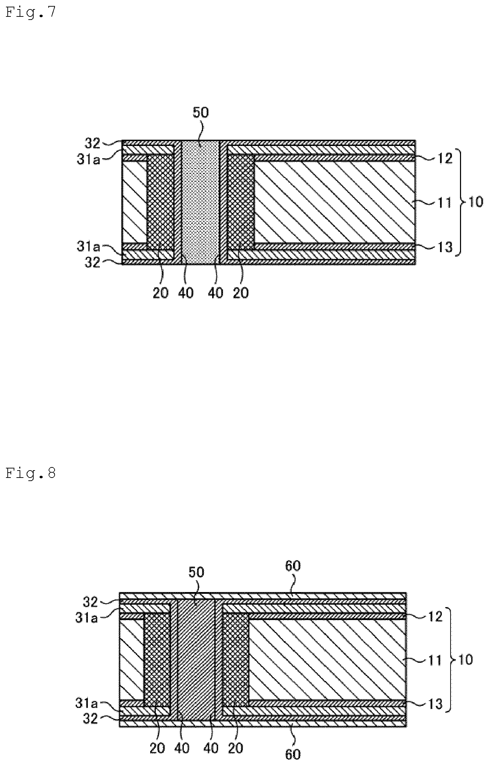

After the plating film 40 is formed, the insulation paste is filled into the second through-hole 21 in which the plating film 40 is formed, and then cured to form the insulating cured product layer 50, as illustrated in Fig. 7 as an example.

Examples of the method of filling the insulation paste include a method of filling the second through-hole 21 with the insulation paste with use of a squeegee, a method of filling with the insulation paste with use of a cartridge, a method of filling with the insulation paste by mask printing, a roll coat method, and an inkjet method.

The condition for thermally curing the insulation paste can be the same as that for thermally curing the resin composition layer of the metal foil-attached resin sheet.

The insulation paste contains the epoxy resin and the curing agent, and may further contain the inorganic filler, the curing accelerator, and (an) other additive(s) as required. Explanations are given above regarding the epoxy resin, the curing agent, the inorganic filler, the curing accelerator, and other additives. The insulation paste may have the same composition as or different composition from the resin composition.

After the formation of the insulating cured product layer 50, the method may include removing by polishing an excessive amount of the insulation layer 50 that projects out from or is attached to the substrate 10, in order to smoothen the insulating cured product layer 50, as required. The polishing method is described above.

After formed, the insulating cured product layer 50 may be subjected at its surface to roughening treatment. After polished, the surface of the insulating cured product layer 50 may be subjected to the roughening treatment. Either one of dry-type and wet-type roughening treatment can be employed as the roughening treatment. An example of the dry-type roughening treatment includes plasma treatment. An example of the wet-type roughening treatment includes a method of performing a swelling treatment with a swelling solution, a roughening treatment with an oxidizing agent, and a neutralizing treatment with a neutralizing solution in this order. The method of polishing the insulating cured product layer is described above.

### <Process (E-1)>

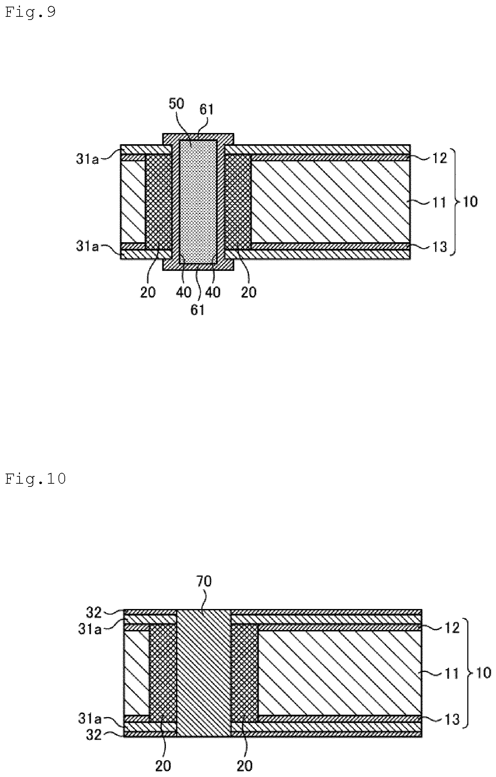

At process (E-1), the patterned conductive layer is formed. In detail, the conductive layer 60 is formed on the insulating cured product layer 50, the plating film 40, and the metal foil 32, as illustrated in Fig. 8 as an example. Furthermore, after the conductive layer 60 is formed, a part of the conductive layer 60 is removed by etching treatment or the like to form the patterned conductive layer 61, as illustrated in Fig. 9 as an example. When a part of the patterned conductive layer 61 is removed, a part of the plating film 40 and a part of the metal foil 32 may be removed as required.

Examples of the method of forming the conductive layer 60 include plating method, sputtering method, and vapor deposition method. Among them, the plating method is preferred. In a preferred embodiment, the surface of the cured product is plated by a suitable method such as semi-additive method or full-additive method to form the patterned conductive layer with a desired wiring pattern. Examples of the material of the conductive layer include: single metals such as gold, platinum, palladium, silver, copper, aluminum, cobalt, chromium, zinc, nickel, titanium, tungsten, iron, tin, and indium; and alloys each made of two or more metals that are selected from the group consisting of gold, platinum, palladium, silver, copper, aluminum, cobalt, chromium, zinc, nickel, titanium, tungsten, iron, tin, and indium. Among these, it is preferable to use chromium, nickel, titanium, aluminum, zinc, gold, palladium, silver, copper, nickel-chromium alloy, copper-nickel alloy, or copper-titanium alloy from the viewpoints of versatility, cost, and ease of patterning and the like. It is more preferable to use chromium, nickel, titanium, aluminum, zinc, gold, palladium, silver, copper, nickel-chromium alloy, copper-nickel alloy, or copper-titanium alloy. The use of copper is still more preferred.

Here, an example of an embodiment for forming the patterned conductive layer 61 is described in detail. A plating seed layer (not illustrated) is formed on the surfaces of the insulating cured product layer 50, the plating film 40, and the metal foil 32 by electroless plating. Next, an electroplating layer is formed on the formed plating seed layer by electrolytic plating to form the conductive layer 60. After the formation of the conductive layer 60, the conductive layer with the desired wiring pattern can be formed by removing unwanted parts of the plating film 40, the metal foil 32, and the plating seed layer and so on by etching or other treatment. After the formation of the patterned conductive layer, annealing treatment may be performed as required for improving the peel strength of the conductive layer or other purposes. The annealing treatment can be performed by heating the circuit board at 150 to 200°C for 20 to 90 minutes, for example.

The thickness of the patterned conductive layer is preferably 70 µm or less, more preferably 60 µm or less, still more preferably 50 µm or less, still further more preferably 40 µm or less, and particularly preferably 30 µm or less, 20 µm or less, 15 µm or less, or 10 µm or less from the viewpoint of thinning. The lower limit is preferably 1 µm or more, more preferably 3 µm or more, and still more preferably 5 µm or more.

### [Second embodiment]

The process (A) in the second embodiment is the same as the process (A) in the first embodiment.

The process (B) in the second embodiment is the same as the process (B) in the first embodiment.

The process (C) in the second embodiment is the same as the process (C) in the first embodiment.

### <Process (D-2)>

In the second embodiment, the process (D-2) is performed after the process (C). At the process (D-2), the electrically conductive paste is filled into the second through-hole and then cured. In detail, after the formation of the second through-hole 21, the electrically conductive paste is filled into the second through-hole and then cured to form the electrically conductive layer 70, as illustrated in Fig. 10 as an example.

Examples of the method of filling with the electrically conductive paste include a method of filling the second through-hole 21 with the electrically conductive paste with use of a squeegee, a method of filling with the electrically conductive paste with use of a cartridge, a method of filling with the electrically conductive paste by mask printing, a roll coat method, and an inkjet method.

The condition for thermally curing the electrically conductive paste can be the same as that for thermally curing the magnetic paste.

### - Electrically conductive paste -

The electrically conductive paste contains an electrically conductive filler, and may contain the binder resin, the curing accelerator, and (an) other additive(s) as required. The binder resin, the curing accelerator, and other additives are described above.

The electrically conductive filler is at least one type selected from metal particles selected from silver, copper, and nickel and metal-coated particles coated with a metal selected from silver, copper and nickel. Examples of the metal particle include silver particle, copper particle, and nickel particle. Examples of the metal-coated particle include metal-coated metal particles obtained by coating metal particles with metals, and metal-coated resin particles obtained by coating metals on resin particles such as polyamide and polybenzoguanamine. Examples of the metal-coated particle include silver-coated particles such as silver-coated metal particles and silver-coated resin particles; copper-coated particles such as copper-coated metal particles and copper-coated resin particles; nickel-coated particles such as nickel-coated metal particles and nickel-coated resin particles; and the like.

The electrically conductive filler is preferably shaped into flake-like (scale-like) or filament-like (dendritic). One type of the electrically conductive filler may be used alone, or two or more types thereof may be used in combination.

The average particle size of the electrically conductive filler is preferably 50 µm or less, more preferably 35 µm or less, still more preferably 20 µm or less, and still further more preferably 10 µm or less from the viewpoint of film formability and electrical conductivity. The lower limit of the average particle size is not particularly limited, but is preferably 0.001 µm or more, more preferably 0.005 µm or more, and still more preferably 0.01 µm or more. The average particle size of the electrically conductive filler can be measured in the same way as the average particle size of the magnetic powder.

From the viewpoint of improving moisture resistance and dispersibility, the electrically conductive filler is preferably treated with one or more of surface treatment agent(s): silane surface treatment agents such as amino silane coupling agents, epoxysilane coupling agents, mercapsilane coupling agents, silane coupling agents, alkoxysilane compounds, organosilazane compounds, titanate coupling agents; and polyester dispersants; and the like.

From the viewpoint of achieving the electrically conductive layer with low resistance, the content of the electrically conductive filler is preferably 40% by mass or more, more preferably 45% by mass or more, and still more preferably 50% by mass or more with respect to 100% by mass of the non-volatile component in the electrically conductive paste. From the viewpoint of adhesion of the electrically conductive layer, the upper limit of the content of the electrically conductive filler is preferably 98% by mass or less, and more preferably 95% by mass or less with respect to 100% by mass of the non-volatile component in the electrically conductive paste.

After formed, the electrically conductive layer 70 may be polished or subjected at its surface to roughening treatment, as required.

### <Process (E-2)>

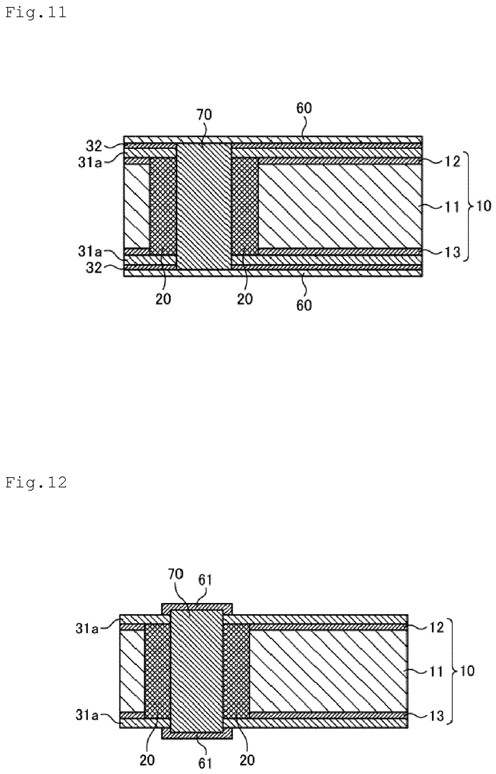

At process (E-2), the patterned conductive layer is formed. In detail, the conductive layer 60 is formed on the electrically conductive layer 70 and the metal foil 32, as illustrated in Fig. 11 as an example. Furthermore, after the conductive layer 60 is formed, a part of the conductive layer 60 is removed by etching treatment or the like to form the patterned conductive layer 61, as illustrated in Fig. 12 as an example. The thickness of the patterned conductive layer is the same as the thickness of the patterned conductive layer in the first embodiment.

The process (E-2) in the second embodiment can be performed in the same way as the process (E-1) in the first embodiment.

The inductor-embedded substrate obtained by the manufacturing method according to the first and the second embodiments can be used as a wiring board to mount thereon electronic components such as semiconductor chips, and can be used also as a (multilayer) printed wiring board in which the wiring board is used as an internal layer substrate. The inductor-embedded substrate can be used also as chip inductor components in which the wiring board is formed into individual chips, and can be used as a printed wiring board with the chip inductor components surface-mounted.

Also, various aspects of semiconductor devices can be manufactured using such wiring boards. The semiconductor devices containing such wiring boards can be suitably used in electrical products (e.g., computers, cellular phones, digital cameras, and televisions) and vehicles (e.g., motorcycles, automobiles, trains, ships, and aircraft).

### [Example]

The present invention is specifically described below with reference to Examples, but the present invention is not limited to these Examples.

### [Example according to first embodiment]

### <Process (A)>

A 0.8 mm thick internal layer substrate ("MCL-E-705GL", copper foil etch-out product, manufactured by Hitachi Chemical Co., Ltd.) was prepared. A first through hole was formed in this internal layer substrate with drill. The first through-hole was formed using a drill "ST" manufactured by Union Tool Co.

A magnetic paste containing an iron alloy filler as a magnetic powder was printed in vacuum in the first through-hole. The magnetic paste was made of a material with a magnetic powder content of 90% by mass, a viscosity of 60 Pa·sec (E-type viscometer, 25°C, 5 rpm measurement environment) and a relative permeability (100 MHz) of 7. After the printing in vacuum, the magnetic paste was thermally cured by heating at 150°C for 30 minutes to form a magnetic layer inside the first through-hole. Next, the surfaces of the internal layer substrate and the magnetic layer were polished and smoothed. The polishing was performed using a ceramic polishing roll #1500 manufactured by Ishiihyoki Co., Ltd.

### <Process (B)>

Next, a metal foil-attached resin sheet ("ABF-GX92-RCC" manufactured by Ajinomoto Fine-Techno Co., Inc.; thickness of resin composition layer: 30 µm; support copper foil) was laminated on both surfaces of the internal layer substrate by vacuum lamination such that the resin composition layer was bonded to the surfaces of the internal layer substrate. After the vacuum lamination, the resin composition layer was thermally cured by heating at 100°C for 30 minutes and then at 180°C for 30 minutes to form an insulation layer.

### <Process (C)>

A second through-hole was formed to have an opening diameter smaller than that of the first through-hole, in the support copper foil, the insulation layer, and the magnetic layer using a drill "NEU" manufactured by Union Tool Co. After the formation of the second through-hole, processing residues inside the second through-hole were removed by high-pressure water washing.

### <Process (D-1)>

After the processing residues were removed by high-pressure water washing, electroless plating was performed to form a 0.7 µm thick plating in the second through-hole. Then, electroplating was performed to form a 22 µm thick plating film in the second through-hole.

An insulative hole-filling paste ("IR-10F" manufactured by SAN-EI Kagaku Co., Ltd.) was printed in vacuum in the second through-hole after the plating film was formed. After the printing in vacuum, the insulative hole-filling paste was thermally cured by heating at 110°C for 30 minutes and then at 150°C for 60 minutes to form an insulating cured product layer. Next, the surface of the insulating cured product layer was polished and smoothed. The polishing was performed using a ceramic polishing roll #1500 manufactured by Ishiihyoki Co., Ltd.

### <Process (E-1)>

After polished the surface of the insulating cured product layer, the surface of the insulating cured product layer was roughened. The electroless plating was performed to form a 0.7 µm thick plating on the polished surface of the insulating cured product layer. Then, the electroplating was performed to achieve a 22 µm thickness to form a conductive layer together with the plating film.

A dry film was laminated on the conductive layer, exposed to light, and processed to be patterned. Next, the patterned conductive layer was formed by subtractive method using an iron chloride etchant. Then, the dry film was peeled off to produce an inductor-embedded substrate.

### [Example according to second embodiment]

### <Process (A)>

A 0.8 mm thick internal layer substrate ("MCL-E-705GL", copper foil etch-out product, manufactured by Hitachi Chemical Co., Ltd.) was prepared. A first through hole was formed in this internal layer substrate with drill. The first through-hole was formed using a drill "ST" manufactured by Union Tool Co.

The magnetic paste was printed in vacuum in the first through-hole. The magnetic paste was made of the material with a magnetic powder content of 90% by mass, a viscosity of 60 Pa·sec (E-type viscometer, 25°C, 5 rpm measurement environment) and a relative permeability (100 MHz) of 7. After the printing in vacuum, the magnetic paste was thermally cured by heating at 150°C for 30 minutes to form the magnetic layer inside the first through-hole. Next, the surfaces of the internal layer substrate and the magnetic layer were polished and smoothed. The polishing was performed using a ceramic polishing roll #1500 manufactured by Ishiihyoki Co., Ltd.

### <Process (B)>

Next, a metal foil-attached resin sheet ("ABF-GX92-RCC" manufactured by Ajinomoto Fine-Techno Co., Inc.; thickness of resin composition layer: 30 µm; support copper foil) was laminated on both surfaces of the internal layer substrate by vacuum lamination such that the resin composition layer was bonded to the surfaces of the internal layer substrate. After the vacuum lamination, the resin composition layer was thermally cured by heating at 100°C for 30 minutes and then at 180°C for 30 minutes to form an insulation layer.

### <Process (C)>

A second through-hole was formed to have an opening diameter smaller than that of the first through-hole, in the support copper foil, the insulation layer, and the magnetic layer using a drill "NEU" manufactured by Union Tool Co. After the formation of the second through-hole, processing residues inside the second through-hole were removed by high-pressure water washing.

### <Process (D-2)>

After the processing residues were removed by high-pressure water washing, an electrically conductive hole-filling paste ("AE2217" manufactured by Tatsuta Electric Wire & Cable Co., Ltd.) was printed in vacuum in the second through-hole. After the printing in vacuum, the electrically conductive hole-filling paste was thermally cured by heating at 60°C for 30 minutes and then at 160°C for 60 minutes to form an electrically conductive layer in the second through-hole. Next, the surface of the electrically conductive layer was polished and smoothed. The polishing was performed using a ceramic polishing roll #1500 manufactured by Ishiihyoki Co., Ltd.

### <Process (E-2)>

The electroplating was performed on surfaces of the internal layer substrate and the electrically conductive layer to have a 22 µm thick plating in order to form the conductive layer together with the support copper foil.

A dry film was laminated on the conductive layer, exposed to light, and processed to be patterned. Next, the patterned conductive layer was formed by subtractive method using an iron chloride etchant. Then, the dry film was peeled off to produce an inductor-embedded substrate.

## Claims

1. A method of manufacturing an inductor embedded substrate, the method comprising following process (A) to process (C) in this order:
(A) filling a resin composition containing magnetic powder into a first through-hole that is formed in a substrate having first and second main surfaces to run between the first and the second main surfaces to form a magnetic layer;
(B) laminating a metal foil-attached resin sheet containing metal foil and a resin composition layer onto the substrate such that the resin composition layer is bonded to the substrate, and curing the resin composition layer to form an insulation layer; and
(C) forming a second through-hole that runs through the metal foil, the insulation layer, and the magnetic layer.

2. The method of manufacturing the inductor embedded substrate according to claim 1, the method further comprising after process (C):
(D-1) forming a plating film in the second through-hole, filling and curing an insulation paste into the second through-hole in which the plating film is formed; and
(E-1) forming a patterned conductive layer.

3. The method of manufacturing the inductor embedded substrate according to claim 1, the method further comprising after process (C):
(D-2) filling the second through-hole with an electrically conductive paste and curing the electrically conductive paste; and
(E-2) forming a patterned conductive layer.

4. The method of manufacturing the inductor embedded substrate according to any one of claims 1 to 3, wherein the magnetic powder is at least one type selected from pure iron powder and iron alloy metal powder.

5. The method of manufacturing the inductor embedded substrate according to any one of claims 1 to 4, wherein the metal foil includes copper foil.

6. The method of manufacturing the inductor embedded substrate according to any one of claims 1 to 5, the method further comprising forming the first through-hole that runs between the first and the second main surfaces of the substrate.
